# EUROPÄISCHE PATENTANMELDUNG

(11) **EP 2 099 273 A1**
(43) Veröffentlichungstag der Anmeldung: **09.09.2009**
(21) Anmeldenummer: 08152211.2
(22) Anmeldetag: 03.03.2008
(51) Int. Cl.: H05K 7/14

(54) **Elektronische Steckbaugruppe zur Aufnahme in einen Baugruppenträger**

(71) Anmelder: Schroff GmbH, 75334 Straubenhardt (DE)
(72) Erfinder: Mazura, Paul, 76307, Karlsbad (DE); Rieger, Uwe, 76307, Karlsbad (DE); Joist, Michael, 76571, Gaggenau (DE)
(74) Vertreter: Petirsch, Markus

(57) **Zusammenfassung**

Eine elektronische Steckbaugruppe (5) zur Aufnahme in einem Baugruppenträger (1) mit einer Modulschiene (2) im Frontbereich umfasst eine Leiterplatte (6), einen Leiterplattenhalter (17) und einen Adapter (10). Der Adapter (10) hat eine Aufnahme (12) für ein Befestigungselement (13) zur Befestigung des Adapters (10) an der Modulschiene (2). Der Leiterplattenhalter (17) am vorderen Eckbereich der Leiterplatte (6) ist an der Leiterplatte (6) befestigt. Er weist eine Kupplungsstruktur (26) auf, an die ein korrespondierendes Kupplungselement (23) des Adapters (10) ankoppelt, um eine Kopplung zwischen dem Leiterplattenhalter (17) und dem Adapter (10) zu bilden. In einer Endposition der Steckbaugruppe (5) in dem Baugruppenträger (1) wirken der Adapter (10) und der Leiterplattenhalter (17) derart zusammen, dass die Steckbaugruppe (5) in ihrer Position in dem Baugruppenträger (1) gehalten wird.

## Beschreibung

Die vorliegende Erfindung betrifft eine elektronische Steckbaugruppe zur Aufnahme in einem Baugruppenträger mit einer Modulschiene im Frontbereich, umfassend eine Leiterplatte, einen Leiterplattenhalter und einen Adapter.

Modular aufgebaute elektronische Geräte umfassen einen Baugruppenträger, in den einzelne Module in Form von Steckbaugruppen eingesteckt werden können. Die Steckbaugruppen weisen an ihrer Rückseite einen mehrpoligen Stecker auf, der in einen Steckverbinder (Steckeraufnahme) an der "Backplane" des Baugruppenträgers eingesteckt wird. Der Stecker der Steckbaugruppe kann entweder ein integrierter Stecker sein, z. B. eine Steckerleiste, eine Steckerzunge oder ein "Card-Edge-Connector", oder eine separate Steckerleiste, die an der Steckbaugruppe befestigt ist.

Um die Steckbaugruppen in ihrer Position innerhalb des Baugruppenträgers zu halten, werden sie durch geeignete Verriegelungselemente befestigt. Übliche Verriegelungen, die ein unbeabsichtigtes Herauslösen der Baugruppen verhindern, sind Schrauben oder Schnellverschlüsse. Dabei wird entweder ein an der Leiterplatte befestigter Hebel oder Hebelziehgriff verwendet, der mit einer frontseitigen Modulschiene des Baugruppenträgers zusammenwirkt, oder es wird eine Frontplatte der Steckbaugruppe mittels einer Schraube an der Modulschiene angeschraubt. Die Steckbaugruppe wird dazu soweit in den Baugruppenträger hineingeschoben, bis die Frontplatte an der Modulschiene des Baugruppenträgers fest anliegt.

Im Bereich der modernen Telekommunikationssysteme werden Steckbaugruppen (Module) nach dem AMC-Standard (Advanced Mezzanin Card) entwickelt, der von der PIGMG (PCI Industrial Computer Manufacturers Group) festgelegt wird. Baugruppen dieser Spezifikation sind im Vergleich zu bekannten 19-Baugruppen relativ klein und haben eine vergleichsweise kürzere Frontplatte, die in ihrer Höhe die Leiterplatte der Steckbaugruppe nicht überragt. Die Frontplatte kann an der Leiterplatte der Steckbaugruppe vormontiert sein. Sie weist in der Regel einen U-förmigen Querschnitt auf. Der Stecker der AMC-Steckbaugruppe ist in der Leiterplatte an ihrem hinteren Ende in Form einer Steckerzunge (Card-Edge-Connector) integriert.

AMC-Steckbaugruppen verfügen aufgrund ihrer normativ festgelegten Dimensionen und zulässigen Toleranzen nicht über die bekannten Befestigungsflansche an der Frontplatte, da die Steckbaugruppen auch in so genannte Carrier (Adapter) eingesetzt werden sollen, die keine korrespondierende Montageebene oder Befestigungsschiene (Modulschiene) am Baugruppenträger aufweisen. Der Tiefenanschlag der Module (in Einschubrichtung) innerhalb der Carrier erfolgt über die hinterste Kante der Leiterplatte. Der Tiefenanschlag ist für eine sichere Kontaktübergabe der einzelnen Kontaktreihen der Steckerzunge mit dem Steckverbinder (Steckeraufnahme) des Carriers notwendig. Ein besonderer normativ spezifizierter Verriegelungsmechanismus dieser Module (Card-Edge-Systeme) sichert deren Endposition. Durch die gestiegenen Anforderungen in Bezug auf Schock- und Vibrationsfestigkeit der Systeme gelangen die bekannten Befestigungsmöglichkeiten jedoch an ihre Grenzen.

Aufgrund der in der Norm festgelegten und zugelassenen Toleranzen der einzelnen Bauteile der AMC-Systeme, insbesondere der Steckbaugruppen und Baugruppenträger, ist es nicht ohne weiteres möglich, Befestigungsflansche an der Frontplatte vorzusehen, die an einer Befestigungsschiene des Baugruppenträgers anschlagen und auf diese Weise gleichzeitig die Kontaktierung der Steckbaugruppe mit dem Baugruppenträger sicher stellen. Beispielsweise würde ein Festschrauben der Frontplatte an dem Baugruppenträger einen möglicherweise zu hohen Druck auf den integrierten Stecker der Steckbaugruppe oder das Steckergehäuse des Steckverbinders ausüben, so dass die Leiterplatte oder die Steckerzunge der Steckbaugruppe beschädigt oder zerstört werden könnte.

Der Erfindung liegt die Aufgabe zugrunde, Steckbaugruppen, insbesondere nach dem AMC-Standard, vorzuschlagen, die in Baugruppenträgern aufgenommen werden können und eine zuverlässige Befestigung bieten.

Gelöst wird die vorliegende Aufgabe durch eine elektronische Steckbaugruppe mit den Merkmalen des Anspruchs 1, durch eine Befestigungsvorrichtung mit den Merkmalen des Anspruchs 9 und durch ein Verfahren zur Befestigung einer Steckbaugruppe in einen Baugruppenträger mit den Merkmalen des Anspruchs 10.

Die erfindungsgemäße Steckbaugruppe zur Aufnahme in einen Baugruppenträger mit einer Modulschiene im Frontbereich umfasst eine Leiterplatte, einen Leiterplattenhalter und einen Adapter. Der Leiterplattenhalter ist im vorderen Eckbereich der Leiterplatte an dieser befestigt. Er weist eine Kupplungsstruktur auf, die an ein korrespondierendes Kupplungselement des Adapters ankoppelt, so dass eine Kopplung zwischen dem Leiterplattenhalter und dem Adapter gebildet wird. Der bevorzugt abgewinkelte Adapter hat zusätzlich eine Aufnahme für ein Befestigungselement, damit der Adapter an der Modulschiene des Baugruppenträgers befestigbar ist. Durch die Verbindung von Adapter und Baugruppenträger sowie die Kopplung zwischen Adapter und Leiterplattenhalter wird folglich die Steckbaugruppe mit dem Baugruppenträger befestigt. Wenn die Steckbaugruppe vollständig in den Baugruppenträger eingeschoben ist und sie sich in einer Endposition befindet, wirken der Adapter und der Leiterplattenhalter derart zusammen, dass die Steckbaugruppe in ihrer Position in dem Baugruppenträger gehalten wird.

Die aus Adapter und Leiterplattenhalter bestehende erfindungsgemäße Befestigungsvorrichtung weist den Vorteil auf, dass sie unabhängig von einer Frontplatte der Steckbaugruppe ist. Insbesondere kann die Befestigungsvorrichtung auch bei Steckbaugruppen nachgerüstet werden, deren Frontplatte keine Befestigungsflansche aufweist, um die Frontplatte und somit die mit der Frontplatte befestigte Steckbaugruppe in dem Baugruppenträger zu befestigen und fixieren. Die Befestigungsvorrichtung lässt sich auch auf Steckbaugruppen anwenden, die keine Frontplatte umfassen.

In einer neuen normativen Entwicklung der PICMG werden AMC-Steckbaugruppen spezifiziert, die zukünftig in "ruggedized MTCA"-Baugruppenträger verwendet werden sollen, welche in ihrem Frontbereich eine Befestigungsschiene aufweisen. Derartige Baugruppenträger und AMC-Steckbaugruppen sollen an die neuen, erhöhten Anforderungen im Hinblick auf Schock- und Vibrationsbelastungen angepasst sein. Die bisherigen AMC-Module, die über eine kürzere Frontplatte ohne Befestigungsflansche verfügen, müssen für den Einsatz in die "ruggedized MTCA"-Baugruppenträger modifiziert werden. Dies müsste durch Austausch der Frontplatten der Module geschehen, da die bisherigen Frontplatten keine Frontbefestigung bieten. Derart modifizierte Frontplatten mit Befestigungsflanschen könnten dann an der Befestigungsschiene fixiert werden, wie es in der EP 08 000 146.4 (EP-Anmeldung) beschrieben ist.

Die erfindungsgemäße Befestigungsvorrichtung weist den Vorteil auf, dass auch "normale" AMC-Module für MicroTCA-Baugruppenträger aufgerüstet werden können. Die Steckbaugruppen nach der derzeit gültigen "AMC.0-Norm" mit der verkürzten Frontplatte ohne Befestigungsflansche können verwendet werden.

Durch Verwendung der erfindungsgemäßen Befestigungsvorrichtung kann auf den (teuren) Austausch der (teilweise individualisierten) Frontplatte verzichtet werden, um eine robuste, starke und zuverlässige Fixierung der Steckbaugruppe in den Baugruppenträger zu erzielen. Durch den zusätzlichen Adapter können die bestehenden Frontplatten beibehalten werden. Die Nachrüstung ist damit deutlich kostengünstiger als der Austausch der vorhandenen Frontplatte durch eine modifizierte (verlängerte) Frontplatte. Für alle AMC-Module können so die gleichen Frontplatten verwendet und in größerer Stückzahl zu geringeren Kosten produziert werden.

Im Rahmen der Erfindung wurde festgestellt, dass das Zusammenwirken von Adapater und Leiterplattenhalter besonders geeignet ist für Steckbaugruppen, deren Leiterplatte eine integrierte Steckerzunge (Card-Edge-Connector) umfasst. Bei derartigen Leiterplatten ist es besonders wichtig, dass die von einer Befestigungsvorrichtung zum Fixieren und Befestigen der Steckbaugruppe aufgebrachten Kräfte nicht unkontrolliert auf die Leiterplatte und die Steckerzunge an deren Ende übertragen sondern kontrolliert werden. Anderenfalls können Beschädigungen der Leiterplatte auftreten.

Erfindungsgemäß wird dieser Aspekt bei der Befestigungsvorrichtung auch die Kopplung zwischen Leiterplattenhalter und Adapter berücksichtigt, die eine Relativbewegung der beiden Elemente zulässt. Diese Relativbewegung ist auch dann möglich, wenn der Adapter der Befestigungsvorrichtung an der Modulschiene des Baugruppenträgers befestigt bzw. fixiert ist. In einer bevorzugten Ausführungsform ist eine Relativbewegung zwischen dem Adapter und dem Leiterplattenhalter (während der Kopplung der beiden Elemente) derart möglich, dass die Steckbaugruppe (bevorzugt ausschließlich) in Einschubrichtung im Baugruppenträger bewegbar ist, solange ihre Endposition im eingeschobenen Zustand nicht erreicht ist. Die Befestigungsvorrichtung (bestehend aus Adapter und Leiterplattenhalter), insbesondere die Kopplung zwischen Leiterplattenhalter und Adapter, lässt eine Relativbewegung zwischen beiden Teilen zu, so dass die auf die Leiterplatte der Steckbaugruppe übertragene Kraft begrenzt werden kann.

Die Relativbewegung bietet die Möglichkeit, zuerst den Adapter an die Modulschiene des Baugruppenträgers zu befestigen, z. B. anzuschrauben, und anschließend die Steckbaugruppe in den Baugruppenträger hineinzuschieben, bis der Leiterplattenhalter mit dem Adapter in Eingriff kommt. Durch die besondere Art der Kopplung ist ein Weiterschieben der Steckbaugruppe in Einschubrichtung auch nach dem Ineingriffbringen von Adapter und Leiterplattenhalter möglich, so dass die Steckbaugruppe manuell in ihre Endposition geschoben werden kann. Nach Erreichen der Endposition ist eine Relativbewegung der beiden Teile ausgeschlossen, weil der Leiterplattenhalter aufgrund der Kopplung nicht entgegen der Einschubrichtung bewegt werden kann (und ein Bewegen in Einschubrichtung in der Endposition ausgeschlossen ist). Die Steckbaugruppe wird sicher in ihrer Position in dem Baugruppenträger gehalten. Auch erhöhte Anforderungen an Vibrationen oder Schockbeanspruchungen werden durch diese Ausführungsform erfüllt.

Durch das manuelle Eindrücken der Steckerzunge der Leiterplatte in die Steckeraufnahme an der Backplane des Baugruppenträgers kann die aufzubringende Kraft einfach kontrolliert werden. Die Leiterplatte wird nicht durch überhöhte Kräfte, die durch Schrauben oder Hebel erzeugt werden, beansprucht.

Ein weiterer Vorteil der erfindungsgemäßen Steckbaugruppe ist darin zu sehen, dass durch den vorzugsweise metallischen Adapter mit dem bevorzugt ebenfalls leitfähigen Leiterplattenhalter eine leitfähige Kontaktierung der Steckbaugruppe mit dem Baugruppenträger hergestellt wird. Damit wird gleichzeitig die (elektromagnetischen) Abschirmung des Baugruppenträgers verbessert.

In einer bevorzugten Ausführungsform der Steckbaugruppe ist die Befestigungsvorrichtung derart ausgebildet, dass die Kupplungsstruktur des Leiterplattenhalters eine Raststruktur ist und das korrespondierende Kupplungselement des Adapters ein Rastelement ist. Die Kopplung zwischen Leiterplattenhalter und Adapter wird durch eine Rastverbindung gebildet. Kupplungsstruktur und Kupplungselement sind zwei korrespondierende Teile, z. B. zwei Rasten, die ineinander greifen können. Die Rastverbindung lässt dabei bevorzugt mehrere Stellungen der beiden Rasten zu. Hierdurch wird auch die relative Bewegung zwischen dem Adapter und dem Leiterplattenhalter ermöglicht. Die Kupplungselemente können beispielsweise Rasthaken, Rastnasen oder federnde Elemente sein, die auf einer Art Zahnschiene als Kupplungsstruktur angreifen. Bevorzugt greift das Rastelement während des Einschiebens der Steckbaugruppe in eine in Einschubrichtung vordere Zahnschiene ein, also in eine Zahnschiene, die möglichst weit von der Frontseite der Leiterplatte entfernt ist. Erst kurz vor Erreichen der Endposition wird das Rastelement des Adapters in eine Rastschiene nahe der Frontseite rastend bewegt.

Alternativ kann das Kupplungselement eine Aufnahme sein und die Kupplungsstruktur eine in die Aufnahme eingreifende und rastende Rastklinke.

Ein bevorzugtes Ausführungsbeispiel einer erfindungsgemäßen Steckbaugruppe wird nachfolgend anhand der Zeichnungen näher beschrieben. Die darin dargestellten Merkmale können einzeln oder in Kombination verwendet werden, um bevorzugte Ausgestaltungen der Erfindung zu schaffen. Sie stellen keine Beschränkung der Allgemeinheit der Erfindung dar. Es zeigen:
- Figur 1: einen Baugruppenträger mit zwei Steckbaugruppen;
- Figur 2: eine erfindungsgemäße Steckbaugruppe mit Adapter und Leiterplattenhalter;
- Figur 3: einen Prinzipschnitt durch einen Baugruppenträger mit der Steckbaugruppe nach Fig. 2;
- Figur 4: eine Ausführungsform einer Steckbaugruppe als Prinzipbild;

- Figuren 5 a - c: eine weitere Ausführungsform einer Steckbaugruppe;
- Figuren 6 a - c: eine Detailzeichnung im Schnitt durch die Steckbaugruppe nach Fig. 5 in einem Baugruppenträger.

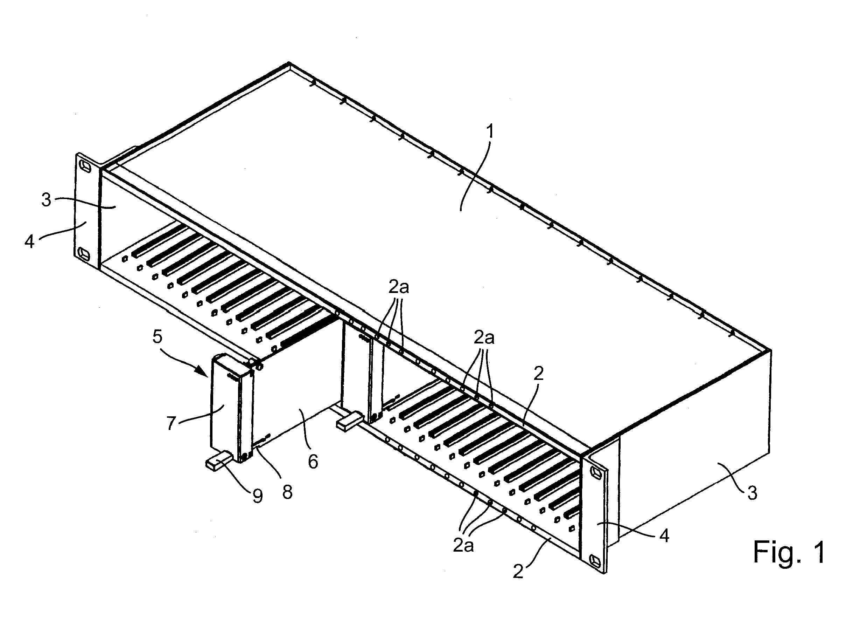

Fig. 1 zeigt einen Baugruppenträger 1, der als MicroTCA-Baugruppenträger (Micro Telecommunications Computing Architecture) ausgebildet ist. Zwei im Frontbereich des Baugruppenträgers 1 angeordnete Modulschienen 2 erstrecken sich zwischen zwei Seitenwänden 3 mit je einem Befestigungsflansch 4, um den Baugruppenträger 1 in einem Schaltschrank befestigen zu können.

Die Modulschienen 2 haben je eine zur Vorderseite des Baugruppenträgers 1 ausgerichtete Lochleiste mit mehreren Bohrungen 2a, in die Befestigungsschrauben zur Befestigung von Steckbaugruppen eingeschraubt werden können. Die Lochleiste kann auch als Nut ausgebildet sein, in die Befestigungselemente mit Schrauben einschraubbar sind, beispielsweise in Klemmmuttern, die in der Nut angeordnet sind.

In dem Baugruppenträger 1 können mehrere Steckbaugruppen 5 aufgenommen werden, die eine Leiterplatte 6 und eine Frontplatte 7 umfassen, wobei die Frontplatte 7 mittels eines (hier nicht sichtbaren) Leiterplattenhalters mit der Leiterplatte 6 verschraubt wird. Um die als AMC-Modul ausgebildete Steckbaugruppe 5 innerhalb des Baugruppenträgers 1 zu fixieren, ist ein Verriegelungsmechanismus 8 vorgesehen, der über einen Verriegelungshebel 9 betätigt wird. Der Verriegelungshebel 9 betätigt optional auch einen Schalter auf der Leiterplatte 6.

Die Steckbaugruppe 5 wird ausschließlich durch den Verriegelungsmechanismus 8 in dem Baugruppenträger 1 gehalten. Die hier gezeigte Frontplatte 7 hat keine Befestigungsflansche, so dass ein Anschrauben an die Modulschiene 2 nicht möglich ist und erhöhte Anforderungen an die Vibrationen nicht erfüllt werden können.

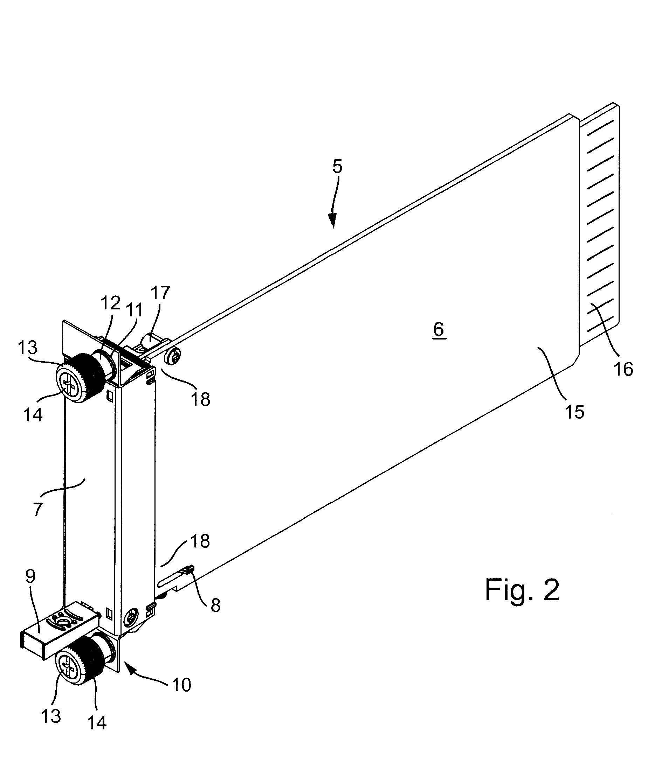

Um die Befestigung der Steckbaugruppe 5 in dem Baugruppenträger 1 zu verbessern und die durch die Modulschiene 2 zur Verfügung gestellten Befestigungsmöglichkeiten zu nutzen, muss entweder die Frontplatte 7 ausgewechselt werden oder die Steckbaugruppe 5 mit einem Adapter 10 nachgerüstet werden, wie es in Fig. 2 gezeigt ist.

Eine erfindungsgemäße Steckbaugruppe 5 in Fig. 2 weist die Leiterplatte 6 und die Frontplatte 7 auf. Oberhalb und unterhalb der Frontplatte 7 ist je ein abgewinkelter Adapter 10, der eine als Öffnung 11 ausgebildete Aufnahme 12 hat, um ein Befestigungselement 13 aufzunehmen. Das Befestigungselement 13 ist eine Schraube 14, die in eine der Bohrungen 2a der Modulschiene 2 eingeschraubt werden kann, um die Steckbaugruppe 5 zuverlässig in dem Baugruppenträger 1 zu fixieren.

Die Leiterplatte 6 hat an ihrem hinteren Ende 15 einen integrierten Stecker in Form einer Steckerzunge 16, wie er z.B. bei AMC-Modulen typisch ist.

Der Adapter 10 ist mit einem Leiterplattenhalter 17 gekoppelt, so dass eine Beweglichkeit des Adapters 10 relativ zu dem Leiterplattenhalter 17 in Längsrichtung der Leiterplatte 6 möglich ist. Der Leiterplattenhalter 17 ist im vorderen Eckbereich 18 der Leiterplatte 6 angeschraubt und hält die im Querschnitt U-förmige Frontplatte 7, deren U-Schenkel sich in Einschubrichtung erstrecken.

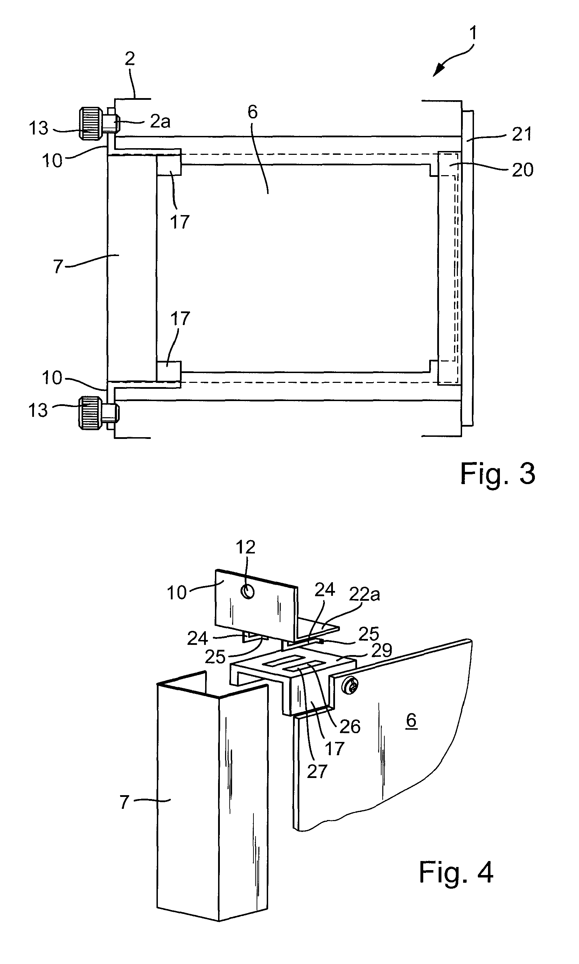

Fig. 3 zeigt eine Prinzipskizze als Schnitt durch einen Baugruppenträger 1, bei dem die Steckbaugruppe 5 in ihrer Funktionsposition angeordnet ist. Die Funktionsposition ist die Endposition der Steckbaugruppe 5 in Einschubrichtung, wenn sich die Steckbaugruppe 5 im eingeschobenen Zustand im Baugruppenträger 1 befindet und die Steckerzunge 16 der Leiterplatte 6 vollständig in einen Steckverbinder 20 (Steckeraufnahme) an einer Backplane 21 des Baugruppenträgers 1 eingesteckt ist. Der obere und untere Adapter 10 kuppeln an den oberen bzw. unteren Leiterplattenhalter 17 der Steckbaugruppe 5 an. Gleichzeitig ist der Adapter 10 an der Modulschiene 2 befestigt. Da die Kopplung zwischen dem Adapter 10 und dem Leiterplattenhalter 17 keine Relativbewegung des Leiterplattenhalters 17 entgegen der Einschubrichtung relativ zu dem Adapter 10 zulässt, ist die Steckbaugruppe 5 in ihrer Endposition im Baugruppenträger 1 fixiert.

In Fig. 3 ist deutlich zu erkennen, dass die ursprüngliche Frontplatte 7 des AMC-Moduls 5 beibehalten wurde, deren vertikale Ausdehnung bevorzugt der Höhe der Leiterplatte 6 entspricht. Die Leiterplatte 6 kann nominal auch etwas kleiner, z. B. 0,3 mm kleiner als die Frontplatte 7 sein.

Wie in den Figuren 3 - 6 gezeigt, ist der Adapter bevorzugt abgewinkelt und bildet vorzugsweise ein L im Längsschnitt. Der sich in Längsrichtung der Leiterplatte 6 erstreckende L-Schenkel 22a des L-förmigen Adapters 10 weist ein Kupplungselement 23 auf.

In einer bevorzugten Ausführungsform wird die Kopplung zwischen dem Leiterplattenhalter 17 und dem Adapter 10 durch eine Rastverbindung gebildet. Das Kupplungselement 23 nach Figur 4 wird von zwei kufenartigen, sich in Einschubrichtung erstreckenden Kupplungsplatten 24 gebildet, die bevorzugt mehrere sich ebenfalls in Längsrichtung der Leiterplatte 6 erstreckende Rasthaken 25 hat. Die Kupplungsplatten 24 sind an der Außenseite des L-Schenkels 22a angeordnet.

Der Leiterplattenhalter 17 ist metallisch ausgebildet und besteht in der Regel aus Vollmaterial, beispielsweise aus Druckguss. In Ausführung nach Fig. 4 ist der Leiterplattenhalter 17 U-förmig ausgeführt, wobei die U-Basis eine Kupplungsstruktur 26 aufweist, die Kupplungsstruktur 26 mit dem Kupplungselement 23 korrespondiert.

Den Figuren 4 - 6 ist auch zu entnehmen, dass die Kupplungsstruktur 26 bevorzugt integraler Bestandteil des Leiterplattenhalters 17 ist. Ebenso ist das Kupplungselement 23 bevorzugt einstückig an den Adapter 10 angeformt.

Die Kupplungsstruktur 26 wird durch zwei sich in Längsrichtung erstreckende Ausnehmungen 27 gebildet, die bevorzugt (hier nicht dargestellte) Rasthaken aufweist, die mit den Rasthaken 25 der Kupplungsplatten 24 korrespondieren. Dabei sind die Kupplungsplatten 24 in ihrer Längsausdehnung kleiner als die Ausnehmungen 27, so dass die Kupplungsplatten 24 in den Ausnehmungen 27 beweglich sind. Damit wird die Relativbewegung zwischen Adapter 10 und Leiterplattenhalter 17 ermöglicht, wobei durch die Rasthaken 25 nur eine Relativbewegung des Leiterplattenhalters 17 in Einschubrichtung gegenüber dem Adapter 10 möglich ist. Eine Relativbewegung entgegen der Einschubrichtung wird durch die Rasthaken verhindert.

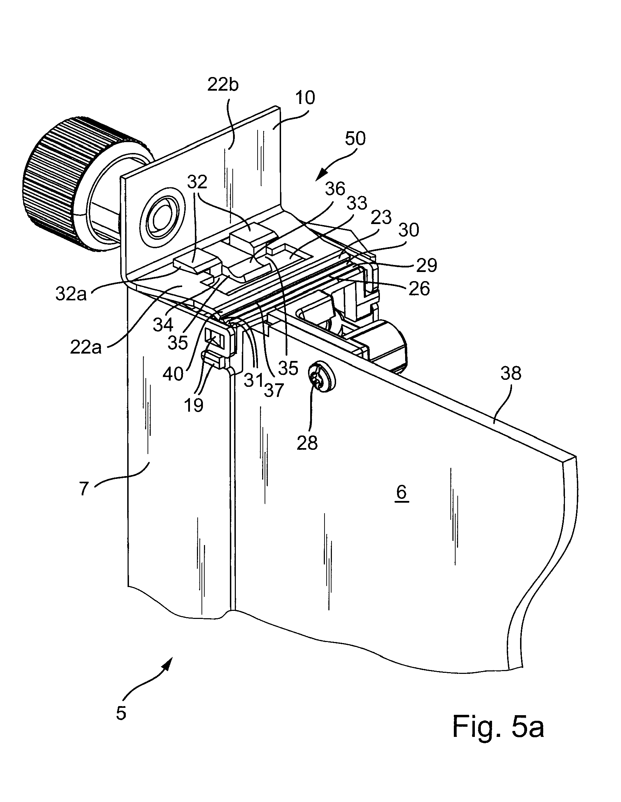

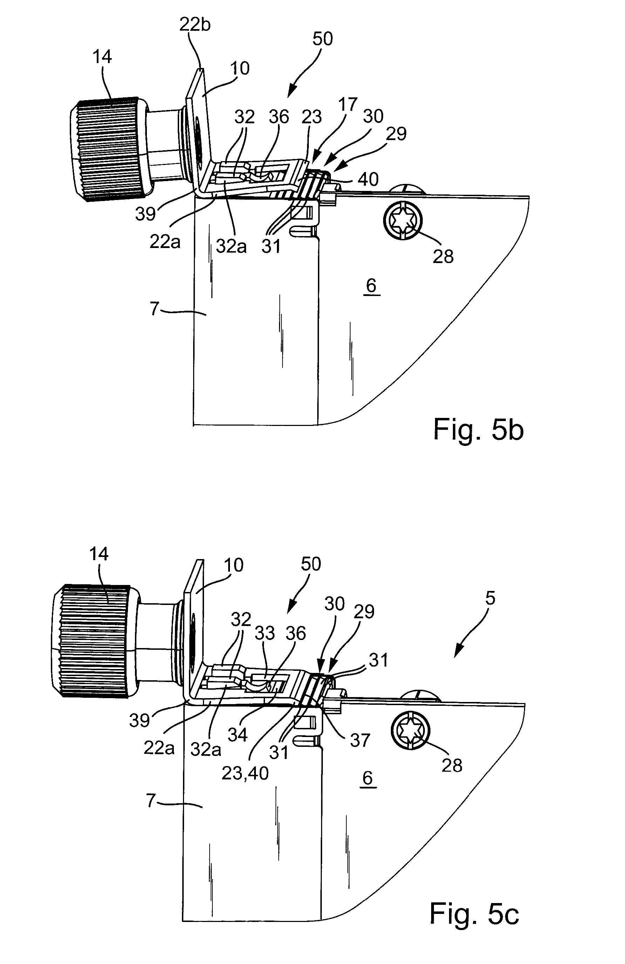

In den Figuren 5 a - c sind Detailaussichten des oberen Eckbereichs einer Steckbaugruppe 5 mit einer Befestigungsvorrichtung 50, die aus dem Adapter 10 und dem Leiterplattenhalter 17 besteht, gezeigt.

Die Leiterplatte 6 ist an dem Leiterplattenhalter 17 mittels einer Halteschraube 28 angeschraubt. Die im Querschnitt U-förmige Frontplatte 7 wird durch eine Klemmverbindung an dem Leiterplattenhalter 17 gehalten. Die Breite (Dimension quer zur Einschubrichtung) des Leiterplattenhalters 17 korrespondiert mit der lichten Weite zwischen den beiden U-Schenkeln der Frontplatte 7. Die Klemmverbindung wird durch eine formschlüssige Verbindung von zwei Haltenasen 19 der Leiterplatten 16 unterstützt, die in korrespondierende Öffnungen in U-Schenkel der Frontplatte 7 eingeklipst sind. Leiterplattenhalter 17 und Frontplatte 7 können auch verschraubt sein. Es ist auch denkbar, dass der Leiterplattenhalter 17 und die Frontplatte 7 einstückig, z.B. als Druckgussteil, ausgebildet sind

Der Leiterplattenhalter 17 weist an seiner Oberseite 29 eine (integrierte) Kupplungsstruktur 26 auf, die mit einem Kupplungselement 23 des Adapters 10 korrespondiert. Als "Oberseite" des Leiterplattenhalters 17 wird die Außenseite verstanden, die sich horizontal erstreckt und von der Leiterplatte 6 abgewandt ist. Bevorzugt fluchtet die Oberseite 29 mit der langen Schmalkante 38 der Leiterplatte 6.

Die Kupplungsstruktur 26 der Oberseite 29 wird durch eine (feine) Rasterung 30 mit einer Mehrzahl von nebeneinander angeordneten, zur Frontplatte 7 hin gekippten Rastzähnen 31 gebildet. Bevorzugt ist der Abstand zweier benachbarter Rastzähne 31 höchstens 1 mm, sehr bevorzugt höchstens 0,5 mm. Besonders bevorzugt ist eine Rasterung 30, bei der der Abstand zweier benachbarter Rastzähne 31 höchstens 0,2 mm, sehr bevorzugt höchstens 0,1 mm beträgt. Jeder einzelne Rastzahn 31 erstreckt sich bevorzugt über die gesamte Breite des Leiterplattenhalters 17, so dass er jeweils eine Rastleiste bildet.

Ebenfalls an der Oberseite 29 des Leiterplattenhalters 17 sind zwei Führungsnasen 32 angeordnet, die im Querschnitt L-förmig sind, wobei sich der horizontale L-Schenkel (Querabschnitt 32a) parallel zur Oberseite 29 erstreckt. Die beiden Führungsnasen 32 korrespondieren mit einer Führungsaufnahme 33 des Adapters 10, wobei die Führungsaufnahme 33 einen verbreiterten ersten Führungsabschnitt 34 und einen verengten zweiten Führungsabschnitt 35 aufweist, der zum vertikalen L-Schenkel 22b des Adapters 10 gerichtet ist. Der erste Führungsabschnitt 34 der Führungsaufnahme 33 ist so ausgebildet, dass die Führungsnasen 32 des Leiterplattenhalters 17 durch den Abschnitt hindurch passen. Der zweite Führungsabschnitt 35 ist derart ausgebildet, dass die Führungsnasen 32 in ihm verschoben werden können, dass jedoch ein Abheben des Adapters (in vertikaler Richtung) verhindert wird. Auf diese Weise kann der Adapter 10 beweglich mit dem Leiterplattenhalter 17 gekoppelt werden und ist dennoch in vorgegebenen Grenzen verschiebbar. Der Adapter 10 weist an seinem freien Ende des L-Schenkels 22a ein Kupplungselement 23 auf, das als Rastelement 40 ausgebildet ist. Das Rastelement 40 mit seiner Rastkante 37 greift in die Rasterung 30 ein, so dass eine Art Verzahnung gebildet wird. Durch die Schrägstellung der Rastzähne ist eine rastende Bewegung ausschließlich in eine Richtung möglich, nämlich derart, dass der Adapter 10 in Richtung Frontplatte 7 relativ zu dem Leiterplattenhalter 17 bewegt werden kann.

Zwischen den beiden zweiten Führungsabschnitten 35 des Adapters 10 ist eine elastisch federnde Führungszunge 36 angeordnet, die auch die beiden ersten Führungsabschnitte 34 trennt. Die Führungszunge 36 übt eine Kraft auf den Adapter 10 aus, so dass der Adapter 10 zur Frontseite der Leiterplatte 6 gekippt ist, Fig. 5 b. Hierdurch ist ein rastfreies Verschieben des Adapters 10 gegenüber dem Leiterplattenhalter 17 möglich. Die oberen Querabschnitte 32a der Führungsnasen 32 sind entsprechend abgeschrägt, so dass der horizontale L-Schenkel 22a des Adapters 10 nach oben verschwenkt werden kann, wobei der Schwenkpunkt die (abgerundete) Winkelspitze 39 des Adapters 10 ist.

Fig. 5 c zeigt die aus Adapter 10 und Leiterplattenhalter 17 gebildete Befestigungsvorrichtung 50, wenn die Federzunge 36 durch eine auf den Adapter wirkende Kraft überwunden wird und der L-Schenkel 22a parallel zur Oberseite 29 ausgerichtet ist. In dieser Raststellung wirkt die am vorderen Ende des Adapters 10 ausgebildete, leicht nach unten abgewinkelte Rastkante 37 des Rastelements 40 mit der Rasterung 30 zusammen, so dass eine Relativbewegung von Adapter 10 und Leiterplattenhalter 17 nur noch in eine Richtung möglich ist. Durch die geneigten Rastzähne 31 wird die Relativbewegung auf eine Bewegung begrenzt, bei der der Leiterplattenhalter 17 und damit die Steckbaugruppe in Einschubrichtung relativ zum Adapter 10 beweglich sind. Eine Relativbewegung entgegen der Einschubrichtung ist ausgeschlossen.

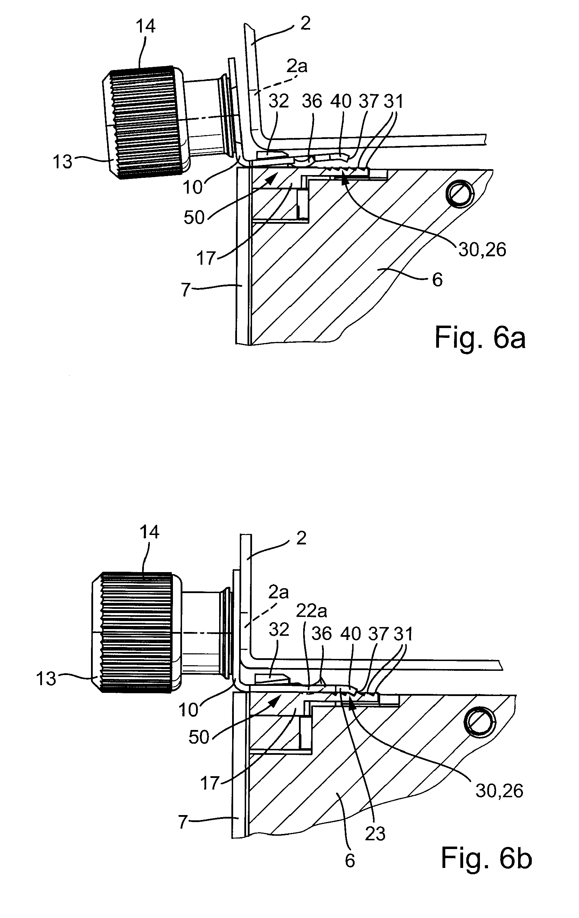

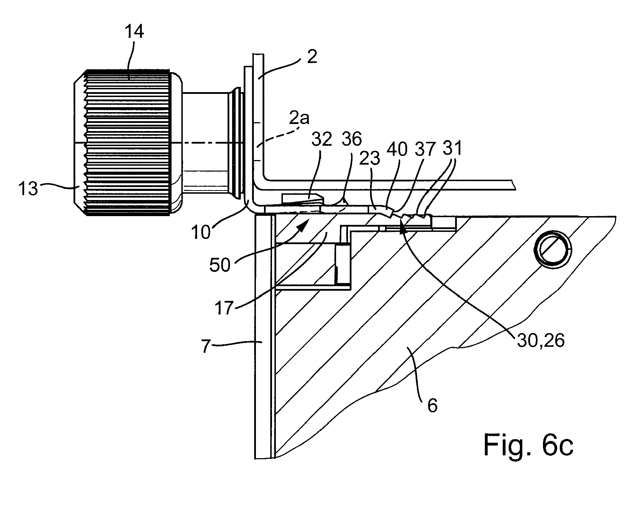

Die Figuren 6 a - c zeigen die Steckbaugruppe 5 aus der Fig. 5 a - c, wobei die Steckbaugruppe 5 in einen Baugruppenträger 1 eingeschoben ist, von dem nur ein Teil der Modulschiene 2 gezeigt ist. In Fig. 6 a ist der Adapter 10 in seiner Startposition angeordnet. Die Führungszunge 36 verschwenkt den Adapter 10 derart, dass das Rastelement 40 von der Rasterung 30 beabstandet ist. Der L-Schenkel 22b ist gegenüber der Vorderseite der Modulschiene 2 geneigt. Der Adapter 10 ist rastfrei gegenüber dem Leiterplattenhalter 17 verschiebbar, wobei die Führungsnase 32 in der Führungsaufnahme 33 geführt wird.

In Fig. 6 a ist die Steckbaugruppe 5 so weit in dem Baugruppenträger 1 eingeschoben, dass ihre Steckerzunge 16 an der Steckeraufnahme 20 der Backplane 21 anliegt.

Fig. 6 b zeigt die Position nachdem der Adapter 10 durch Überwindung der Federkraft der Führungszunge 36 so weit verschwenkt worden ist, dass sein L-Schenkel 22b parallel zur Vorderseite der Modulschiene 2 ausgerichtet ist. Das Rastelement 40 greift in die Rasterung 30 ein und wirkt mit einem der Rastzähne 31 zusammen. Der Adapter 10 ist nun mittels der Schraube 14 (von der das vordere Gewinde aus Übersichtlichkeitsgründen nicht dargestellt ist) an der Modulschiene befestigt, wobei die Schraube 14 in die Bohrung 2a eingeschraubt ist.

Fig. 6 c zeigt die Steckbaugruppe 5, die nun gegenüber der Position in Fig. 6 b um zwei weitere Rastzähne 31 in Einschubrichtung verschoben ist. In dieser Position steckt die Steckerzunge 16 vollständig in der Steckeraufnahme 20 und stellt eine zuverlässige elektrische Kontaktierung her. Deutlich zu erkennen ist, dass aufgrund der Ausbildung des Rastelements 40 und der geneigten Rastzähne 31 ein Verschieben der Steckbaugruppe verhindert wird, da der Leiterplattenhalter 17 nicht entgegen der Einschubrichtung relativ zum Adapter 10 bewegt werden kann.

Der Vergleich der Figuren 6 b und 6 c zeigt jedoch auch, dass aufgrund der normativ zugelassenen Toleranzen der Steckbaugruppen 5 die Steckbaugruppen in unterschiedlichen Positionen innerhalb des Baugruppenträgers fixiert werden können. In Fig. 6 b wäre demnach eine längere Leiterplatte 6 verwendet, so dass sich zwischen der Frontseite der Frontplatte 7 und der Vorderseite der Modulschiene 2 ein Spaltmaß ergibt. Die erfindungsgemäße Befestigungsvorrichtung 50 berücksichtigt ein derartiges Spaltmaß dadurch, dass die Rasterung 30 des Leiterplattenhalters 17 mehrere Positionen in Längsrichtung der Steckbaugruppe zulässt.

Auf diese Weise kann ein Spalt, der sich ergibt, wenn die Steckbaugruppe 5 mit ihrer Steckerzunge 16 die Steckeraufnahme 20 der Backplane 21 vollständig kontaktiert, zwischen der durch die Modulschiene 2 definierte Montageebene und der Frontplatte 7 der Steckbaugruppe 5 aufgrund der Toleranzen berücksichtigt werden. Die Steckbaugruppe 5 muss in dieser Position gehalten werden, insbesondere darf sie nicht aus dem Baugruppenträger 1 heraus bewegt werden. Der sich in dieser Endposition der Steckbaugruppe 5 ergebende Spalt hat ein Spaltmaß von 0 bis ca. 1,6 mm.

Anhand der Figuren 6 a - c lässt sich das erfindungsgemäße Verfahren zur Befestigung einer Steckbaugruppe 5 in einem Baugruppenträger 1 anschaulich beschreiben. Das Verfahren umfasst den Schritt des Einschiebens der Steckbaugruppe 5 in den Baugruppenträger 1 in eine Kontaktposition, bis die integrierte Steckerzunge 16 an der Steckeraufnahme 20 der Backplane 21 anliegt. Ein weiterer Verfahrensschritt umfasst das Befestigen des Adapters 10 mittels des als Schraube 14 ausgebildeten Befestigungselements 13 an der Modulschiene 2 des Baugruppenträgers 1. Ein weiterer Schritt sieht vor, dass das Kupplungselement 23 des Adapters 10 mit der Kupplungsstruktur 26 des Leiterplattenhalters 17 derart in Eingriff gebracht wird, dass eine Kopplung zwischen dem Leiterplattenhalter 17 und dem Adapter 10 gebildet wird. Ein weiterer Schritt umfasst das Bewegen der Steckbaugruppe 5 in Einschubrichtung so weit, bis die Steckbaugruppe 5 aus der Kontaktposition in die Endposition (im vollständig eingeschobenen Zustand), in der das Kupplungselement 23 derart an die Kupplungsstruktur 26 ankoppelt, dass eine Bewegung der Steckbaugruppe 5 entgegen der Einschubrichtung verhindert wird.

Die oben genannten Verfahrensschritte sind in der Reihenfolge beliebig (variabel). Es ist möglich und durchaus bevorzugt, dass der Adapter 10 mit der Modulschiene 2 des Baugruppenträgers 1 verbunden (an ihr befestigt) wird, bevor die Steckbaugruppe 5 in den Baugruppenträger 1 eingeschoben wird. Nach der Befestigung des Adapters 10 an der Modulschiene 2 kann dann die Steckbaugruppe 5 eingeschoben werden, bis die Rastkante 37 des Adapters 10, die das Kupplungselement 23 bildet, mit der als Rasterung 30 ausgebildeten Kupplungsstruktur 26 in Kontakt kommt und mit ihr zusammenwirkt. Dabei lässt die Kopplung zwischen Adapter 10 und Leiterplattenhalter 17 ein Verschieben der Steckbaugruppe 5 in Einschubrichtung zu.

## Patentansprüche

1. Elektronische Steckbaugruppe zur Aufnahme in einem Baugruppenträger (1) mit einer Modulschiene (2) im Frontbereich, umfassend eine Leiterplatte (6), einen Leiterplattenhalter (17) und einen Adapter (10),
wobei
- der Adapter (10) eine Aufnahme (12) für ein Befestigungselement (13) zur Befestigung des Adapters (10) an der Modulschiene (2) umfasst,
- der Leiterplattenhalter (17) im vorderen Eckbereich (18) der Leiterplatte (6) an der Leiterplatte (6) befestigt ist,
- der Leiterplattenhalter (17) eine Kupplungsstruktur (26) aufweist, an die ein korrespondierendes Kupplungselement (23) des Adapters (10) ankoppelt, um eine Kopplung zwischen dem Leiterplattenhalter (17) und dem Adapter (10) zu bilden, und
- in einer Endposition der Steckbaugruppe (5) in dem Baugruppenträger (1) der Adapter (10) und der Leiterplattenhalter (17) derart zusammenwirken, dass die Steckbaugruppe (5) in ihrer Position in dem Baugruppenträger (1) gehalten wird.

2. Steckbaugruppe nach Anspruch 1, **dadurch gekennzeichnet, dass** die Kopplung zwischen dem Leiterplattenhalter (17) und dem Adapter (10) eine Relativbewegung von Adapter (10) und Leiterplattenhalter (17) derart ermöglicht, dass die Leiterplatte (6) der Steckbaugruppe (5) in Einschubrichtung im Baugruppenträger (1) bewegbar ist, solange die Endposition im eingeschobenen Zustand der Steckbaugruppe (5) nicht erreicht ist.

3. Steckbaugruppe nach Anspruch 1 oder 2, **dadurch gekennzeichnet, dass** die Kupplungsstruktur (26) des Leiterplattenhalters (17) eine Raststruktur ist und das korrespondierende Kupplungselement (23) des Adapters (10) ein Rastelement (40) ist und die Kopplung zwischen Leiterplattenhalter (17) und Adapter (10) eine Rastverbindung bildet.

4. Steckbaugruppe nach einem der vorhergehenden Ansprüche, **dadurch gekennzeichnet, dass** der Adapter (10) ein kufenartiges Kupplungselement (23) mit Rasthaken (25) aufweist und die Kupplungsstruktur (26) des Leiterplattenhalters (17) durch eine korrespondierende Ausnehmung (27) mit einer Rastung gebildet wird, so dass eine Rastverbindung zwischen Adapter (10) und Leiterplattenhalter (17) entsteht.

5. Steckbaugruppe nach einem der vorhergehenden Ansprüche, **dadurch gekennzeichnet, dass** der Adapter (10) eine Rastnase hat und die Kupplungsstruktur (26) des Leiterplattenhalters (17) mehrere in Einschubrichtung der Steckbaugruppe (5) im Baugruppenträger (1) angeordnete Rastelemente (40) aufweist, die bevorzugt an einer zur Leiterplatte (6) senkrechten Außenseite des Leiterplattenhalters (17) angeordnet sind.

6. Steckbaugruppe nach einem der vorhergehenden Ansprüche, **dadurch gekennzeichnet, dass**
- der Adapter (10) abgewinkelt ist,
- der sich in Längsrichtung der Leiterplatte (6) erstreckende Schenkel (22a) das Kupplungselement (25) aufweist, und
- sich der senkrecht zur Längsrichtung der Leiterplatte (6) erstreckende Schenkel (22b) die Aufnahme (12) für das Befestigungselement (13) umfasst.

7. Steckbaugruppe nach einem der vorhergehenden Ansprüche, **dadurch gekennzeichnet, dass** die Leiterplatte (6) einen integrierten rückseitigen Steckerzunge (16) hat, der in eine Steckeraufnahme (20) an einer Backplane (21) des Baugruppenträgers (1) einsteckbar ist.

8. Steckbaugruppe nach einem der vorhergehenden Ansprüche, **dadurch gekennzeichnet, dass** die Steckbaugruppe (5) eine Frontplatte (7) umfasst, die an dem Leiterplattenhalter (17) befestigt ist.

9. Befestigungsvorrichtung für eine Steckbaugruppe mit einer Leiterplatte in einem Baugruppenträger (1) mit einer Modulschiene (2) im Frontbereich umfassend einen Leiterplattenhalter (17) der in der vorderen Ecke (18) der Leiterplatte (6) mit der Leiterplatte (6) befestigbar ist, und einen Adapter (10),
wobei
- der Adapter (10) eine Aufnahme (12) für ein Befestigungselement (13) zur Befestigung des Adapters (10) an der Modulschiene (2) umfasst,
- der Leiterplattenhalter (17) eine Kupplungsstruktur (26) aufweist, an die ein korrespondierendes Kupplungselement (23) des Adapters (10) ankoppelt, um eine Kopplung zwischen dem Leiterplattenhalter (17) und dem Adapter (10) zu bilden, und
- in einer Endposition der Steckbaugruppe (5) in dem Baugruppenträger (1) der Adapter (10) und der Leiterplattenhalter (17) derart zusammenwirken, dass die Steckbaugruppe (5) in ihrer Position in dem Baugruppenträger (1) gehalten wird.

10. Verfahren zur Befestigung einer Steckbaugruppe in einem Baugruppenträger, wobei
- der Baugruppenträger (1) eine Modulschiene (2) im Frontbereich und eine Steckeraufnahme (20) an einer Backplane (21) hat,
- die Steckbaugruppe (5) eine Leiterplatte (6) mit einer integrierten rückseitigen Steckerzunge (16), einen Leiterplattenhalter (17) und einen Adapter (10) aufweist,
- der Leiterplattenhalter (17) an der Leiterplatte (6) befestigt ist,
- der Leiterplattenhalter (17) eine Kupplungsstruktur (26) aufweist,
- der Adapter (10) ein Kupplungselement (23) hat, das mit der Kupplungsstruktur (26) des Leiterplattenhalters (17) korrespondiert,
- der Adapter (10) eine Aufnahme (12) für ein Befestigungselement (13) zur Befestigung des Adapters (10) an der Modulschiene (2) umfasst, insbesondere zur Befestigung einer Steckbaugruppe (5) nach Anspruch 1,
**gekennzeichnet durch** die folgenden Schritte:
- Einschieben der Steckbaugruppe (5) in den Baugruppenträger (1), bis die integrierte Steckerzunge (16) an der Steckeraufnahme (20) der Backplane (21) anliegt,
- Befestigen des Adapters (10) mittels des Befestigungselements (13) an der Modulschiene (2) des Baugruppenträgers (1),
- in Eingriffbringen des Kupplungselements (23) des Adapters (10) mit der Kupplungsstruktur (26) des Leiterplattenhalters (17) derart, dass eine Kopplung zwischen dem Leiterplattenhalter (17) und dem Adapter (10) gebildet wird,
- Bewegen der Steckbaugruppe (5) in Einschubrichtung, bis die Steckbaugruppe (5) ihre Endposition im eingeschobenen Zustand erreicht hat und das Kupplungselement (23) derart an die Kupplungsstruktur (26) ankoppelt, dass eine Bewegung der Steckbaugruppe (5) entgegen der Einschubrichtung verhindert wird.
